# EUROPÄISCHE PATENTSCHRIFT

(11) **EP 1 943 665 B1**
(45) Veröffentlichungstag und Bekanntmachung des Hinweises auf die Patenterteilung: **16.01.2013**
(21) Anmeldenummer: 06818264.1
(22) Anmeldetag: 17.10.2006
(51) Int. Cl.: H01L 21/687

(54) **HYBRID CHUCK**
HYBRID CHUCK
SUPPORT HYBRIDE

(30) Priorität: 17.10.2005 DE 102005049598
(43) Veröffentlichungstag der Anmeldung: 16.07.2008
(73) Patentinhaber: ATT Advanced Temperature Test Systems GmbH, 82152 Planegg (DE)
(72) Erfinder: EIBL, Markus, 81375 München (DE)
(74) Vertreter: Müller-Boré & Partner Patentanwälte
(86) Internationale Anmeldenummer: PCT/EP2006/010019
(87) Internationale Veröffentlichungsnummer: WO 2007/045444

(56) Entgegenhaltungen:
- EP-A1- 1 429 379
- EP-A2- 0 763 848
- WO-A-2006/022997
- US-A- 5 950 723
- US-A1- 2005 016 467

## Beschreibung

Die Erfindung betrifft eine Vorrichtung und ein Verfahren zum Temperieren eines Substrats und insbesondere zum Temperieren eines Wafers.

Zum Testen von Schaltungsanordnungen auf scheibenförmigen Substraten wie beispielsweise Halbleiterwafem, werden üblicherweise Haltevorrichtungen und insbesondere Waferchucks verwendet, die meist eine planare Auflagefläche für die scheibenförmigen Substrate aufweisen. Für eine Vielzahl von elektrischen Messungen zum Testen eines Substrats ist es notwendig, die Temperatur des Substrats auf einem konstanten, vorbestimmten Wert einzustellen und/oder zu halten.

Dazu werden in einer Substrathaltevorrichtung Heiz- und/oder Kühlelemente ausgebildet oder die Haltevorrichtung wird mit einem herkömmlichen Thermochuck kombiniert. Um die geregelte Temperatur der Vorrichtung auch auf das Substrat zu übertragen, muß sich das Substrat in einem guten thermischen Kontakt mit der Auflagefläche der Haltevorrichtung befinden. Hierzu werden bei herkömmlichen Substrathaltevorrichtungen zum Beispiel Vakuumöffnungen in der Anlagefläche ausgebildet, um damit ein Ansaugen des Substrats zu ermöglichen. Herkömmliche Substrathaltevorrichtungen sind mit einem geschlossenen Kühlkreislauf versehen, bei dem ein Kühlfluid durch Kanäle in der Substrathaltevorrichtung zu einem Wärmetauscher und wieder zurück zur Substrathaltevorrichtung zirkuliert. Da ein geschlossener Kreislauf nur ein festes, nicht expandierbares Volumen umfaßt, kann es je nach Kühlfluid bei höheren Betriebstemperaturen dazu kommen, daß im Kreislauf hohe Drücke auftreten, so daß die Substrathaltevorrichtung und/oder Teile des Kühlkreislaufes hohen Belastungen ausgesetzt werden. Infolgedessen steigt die Ausfallgefahr und z.B. die Dichtungen im Kreislauf müssen bei herkömmlichen Geräten besonders druckfest ausgelegt werden, wodurch entsprechende Kosten entstehen. Außerdem müssen derartige Geräte regelmäßig aufwendig gewartet werden.

EP 0 763 848 A2 offenbart ein Kühlsystem und ein Verfahren zum Kühlen eines Suszeptors unter Verwendung eines Kühlsystems mit einem ersten Kühlmittel, das aus Düsen auf einen Wärmetauscher gesprüht wird, um zu verdampfen und ein zweites Kühlmittel innerhalb des Wärmetauschers zu kühlen.

US 2005/0016467 A1 offenbart ein System und Verfahren für eine Trockenkammer-Temperaturregelung zum Kompensieren von unbeabsichtigten Anstiegen der Prozesstemperaturen.

US 5 950 723 A offenbart ein Verfahren zum Regulieren der Substrattemperatur in einer Niederdruckumgebung mit einem ersten Fluid für den Wärmeaustausch zwischen einer Heizeinheit und einem Substrat und einem zweiten Fluid für den Wärmeaustausch zwischen der Heizeinheit und der Kühleinheit.

EP 1 429 379 A1 offenbart eine Transportvorrichtung, mit der ein Substrat gehalten und transportiert werden kann. Die Transportvorrichtung weist eine im wesentlichen planare Anlagefläche mit einer Vielzahl von Ansaugrillen auf.

Es ist Aufgabe der Erfindung, eine günstige und zuverlässige Temperierung von Substraten vorzusehen, mit der gewünschte Temperaturänderungen schnell und präzise erfolgen können.

Diese Aufgabe wird durch die Merkmale von Anspruch 1 gelöst. Bevorzugte Ausführungsformen ergeben sich aus den Unteransprüchen.

Somit wird die Aufgabe erfindungsgemäß durch eine Vorrichtung zum Temperieren eines Substrats, insbesondere eines Wafers, gelöst, wobei die Vorrichtung einen durch eine erste Temperiervorrichtung und eine zweite Temperiereinrichtung temperierten Grund- bzw. Hauptkörper aufweist, wobei die erste Temperiereinrichtung zur Temperierung des Hauptkörpers in einem ersten Temperaturbereich zwischen einer ersten Temperatur und einer zweiten Temperatur dient, wobei die erste Temperatur niedriger als die zweite Temperatur ist, und mittels eines ersten Temperierfluids temperiert wird, und die zweite Temperiereinrichtung zur Temperierung des Hauptkörpers in einem zweiten Temperaturbereich zwischen einer dritten Temperatur und einer vierten Temperatur dient, wobei die dritte Temperatur niedriger als die vierte Temperatur ist, und die zweite Temperiereinrichtung mittels eines zweiten Temperierfluids temperiert wird, wobei die zweite Temperatur niedriger als die vierte Temperatur ist und sich das erste Temperierfluid vom zweiten Temperierfluid unterscheidet. Dies hat den Vorteil, daß das erste und zweite Temperierfluid nach den gewünschten physikalischen Eigenschaften wie z.B. den druck- und temperaturabhängigen Aggregatszuständen (fest, flüssig, gasförmig), den gewünschten Strömungseigenschaften (Viskosität, Neigung zum Übergang in turbulente Strömungen, etc.), Wärmekapazität, Wärmeleitfähigkeit, Wärmeübergang an bestimmten festen Flächen und/oder Taupunkte bei Gasen mit kondensierbaren Anteilen u. s. w. jeweils für einen bestimmten Betriebsbereich passend gewählt werden kann. Jede der beiden Temperiereinrichtungen kann in einem Bereich betrieben werden, in dem die andere Temperiereinrichtung mit dem anderen Temperierfluid weniger geeignet wäre. Bevorzugt liegt dabei der Gesamttemperaturbereich, in dem die Vorrichtung betrieben wird, zwischen einer ersten Temperatur von etwa -75° C (198,15 Kelvin) und einer vierten Temperatur von etwa 400° C (673,15 Kelvin). Die zweite Temperatur liegt bevorzugt bei 300° C (573,15 Kelvin), besser noch bei etwa 200° C (473,15 Kelvin) und am vorteilhaftesten bei etwa 100° C (373,15 Kelvin). Die dritte Temperatur liegt bevorzugt im Bereich der ersten Temperatur, kann aber auch darüber bis in den Bereich der zweiten Temperatur liegen. Ein Vorteil eines Betriebes der zweiten Temperiervorrichtung bis zu einer Temperatur im Bereich der ersten Temperatur liegt darin, daß dann bis zu diesem Bereich die erste und die zweite Temperiereinrichtung parallel arbeiten und so zu schnelleren Temperaturänderungen beitragen können. Ein Vorteil eines Betriebs der zweiten Temperiereinrichtung bis zu einer unteren dritten Temperatur (knapp) unterhalb der zweiten Temperatur kann z.B. dann bestehen, wenn Parameter wie z.B. der Taupunkt eines gasförmigen Temperierfluids beachtet werden müssen. Bei einer höheren dritten Temperatur, ist es in einem solchen Fall nicht notwendig, das verwendete Gas so stark zu trocknen, wie das bei tieferen Temperaturen notwendig wäre.

Bevorzugt ist bei einer solchen Vorrichtung das erste Temperierfluid ein flüssiger Alkohol. Noch bevorzugter ist das erste Temperierfluid ein Thermoöl auf Silikonöl-Basis. Am bevorzugtesten wird ein Temperierfluid verwendet, das perfluorierten Polyether, Poly(oxyperfluoro-n-alkylen) und/oder eine Mischung aus Triethoxyalkylsilanen enthält.

Vorteilhaft ist ferner eine Vorrichtung, bei der das zweite Temperierfluid Luft oder Stickstoff ist.

Bei einer ferner bevorzugten Vorrichtung weist die erste Temperiereinrichtung einen vorteilhafter Weise im wesentlichen geschlossenen ersten Temperiermittelkreislauf auf, der zur Temperierung von einem ersten Temperierfluid durchströmt wird, wobei der erste Temperiermittelkreislauf derart gestaltet ist, daß das erste Temperierfluid, wenn es den Bereich des temperierten Hauptkörpers durchströmt hat, zumindest im Betriebsbereich zwischen der ersten Temperatur und der zweiten Temperatur zumindest zum Teil in dem Temperiermittelkreislauf verbleibt. Dies birgt den Vorteil, daß ein Temperierfluid nach Gebrauch nicht ersetzt werden muß, sondern zumindest teilweise wiederverwendet werden kann. Ein weiterer Vorteil ist, daß das Fluid - zumindest im stationären Betrieb, also wenn eine eingestellte Temperatur gehalten werden soll - wenn es aus dem zu temperierenden Bereich austritt eine Temperatur unwesentlich über oder unter der Eintrittstemperatur aufweist, so daß in einer externen Temperiervorrichtung in dem das Fluid auf Eintrittstemperatur gebracht werden soll, nur ein geringer Temperaturunterschied ausgeglichen werden muß, wodurch Energie gespart werden kann. Um Druckspitzen auszugleichen, kann vorteilhaft ein Überdruckventil vorgesehen werden. Vorteilhaft ist ferner, daß in einem geschlossenen Kreislauf auch Fluide verwendet werden können, die nicht in die Umgebung gelangen dürfen, etwa weil sie nachteilige Auswirkungen auf die Umwelt oder auf Teile der Apparatur haben können.

Bevorzugt ist ferner eine solche Vorrichtung, bei der das erste Temperierfluid im Temperaturbereich zwischen der ersten Temperatur und der zweiten Temperatur bis zu einem vorgegebenen ersten Maximaldruck einen flüssigen Aggregatszustand aufweist. Dies hat den Vorteil, daß der Wärmeübergangskoeffizient von Flüssigkeiten an festen Wänden in der Regel höher ist, als der Wärmeübergangskoeffizient von Gasen an festen Wänden. So kann bei vorgegebener Fläche bei Verwendung von flüssigen Fluiden mehr Wärme pro Zeiteinheit übertragen werden, so daß eine bestimmte Temperatur schneller eingepegelt werden kann als bei Verwendung von gasförmigen Fluiden.

Vorteilhafter Weise ist eine erfindungsgemäße Vorrichtung so gestaltet, daß der Teil des ersten Temperiermittelkreislaufes, der sich in dem Bereich des temperierten Hauptkörpers befindet, bevorzugt über ein Absperrventil von dem restlichen Bereich des ersten Temperierkreislaufes abgesperrt werden kann und/oder mit einem Druckentlastungsbereich verbunden werden kann. Dies hat z.B. den Vorteil, daß in einem Temperaturbereich des temperierten Hauptkörpers, in dem der Fluiddruck des verwendeten ersten Temperierfluids einen zulässigen Maximaldruck übersteigen würde, der Bereich des Temperiermittelkreislaufs, der dieser Temperatur ausgesetzt ist, zumindest teilweise entleert werden kann oder mit einem Druckentlastungsbereich (wie z.B. einem Reservoir oder einem Ausgleichbehälter) verbunden werden kann, so daß ein Druckanstieg über einen vorbestimmten bzw. vorbestimmbaren Wert verhindert wird.

Bevorzugt ist ferner eine Vorrichtung, bei der die zweite Temperiereinrichtung zur Temperierung des Hauptkörpers einen zweiten geschlossenen Temperiermittelkreislauf aufweist, der zur Temperierung von einem zweiten Temperierfluid durchströmt wird. In Bezug auf die Vorteile einer solchen Ausführungsform kann auf die in Bezug auf die erste Temperiereinrichtung gemachten Ausführungen verwiesen werden.

Bei einer Vorrichtung entsprechend der Erfindung weist vorteilhafter Weise das zweite Temperierfluid im Temperaturbereich zwischen der dritten Temperatur und der vierten Temperatur bis zu einem vorgegebenen zweiten Maximaldruck einen flüssigen Aggregatszustand auf. In Bezug auf die Vorteile einer solchen Ausführungsform kann auf die in Bezug auf die erste Temperiereinrichtung gemachten Ausführungen verwiesen werden.

Vorteilhaft ist ferner eine Vorrichtung, bei der das zweite Temperierfluid im Temperaturbereich zwischen der dritten Temperatur und der vierten Temperatur einen flüssigen oder einen gasförmigen Aggregatszustand aufweist. Dies hat den Vorteil, daß Druckspitzen im Kreislauf leichter vermieden werden können, als das bei einem flüssigen Fluid der Fall ist. Außerdem können mit einem gasförmigen Fluid höhere Strömungsgeschwindigkeiten verwirklicht werden, so auch bei Wärmeübergangskoeffizienten für "Gase an Wandungen" große Wärmeflüsse verwirklicht werden können. Insbesondere in einem Betriebsbereich bei dem der Hauptkörper von einer Temperatur über der zweiten Temperatur herabgekühlt werden soll - also in einem Bereich, in dem die erste Temperiereinrichtung aufgrund der hohen Drücke nicht betrieben werden kann - kann wegen der in diesem Fall in der Regel vorliegenden großen Temperaturunterschiede zwischen dem Temperierfluid und dem Hauptkörper auch durch eine Gasströmung eine effektive Kühlwirkung erzielt werden.

Bei einer besonders bevorzugten Vorrichtung weist die zweite Temperiereinrichtung zur Temperierung des Hauptkörpers einen Temperierkörper und eine Anströmvorrichtung auf, wobei die Anströmvorrichtung so gestaltet ist, daß sie den Temperierkörper durch ein zweites Temperierfluid anströmen lassen kann, wobei die zweite Temperiervorrichtung so gestaltet ist, daß das zweite Temperierfluid, nachdem es den Temperierkörper angeströmt hat, nicht wieder in einen Temperierfluidkreislauf rückgeführt wird. Ein Vorteil dieses offenen Systems ist, daß über das austretende Fluid die Raumumgebung um die Temperiervorrichtung herum konditioniert werden kann. Ein weiterer Vorteil liegt in der einfachen Konstruktionsweise, durch die eine solche Vorrichtung billiger herzustellen ist. Auch die Unterhaltskosten könnte durch diese Ausführungsform reduziert werden, wenn als Kühlfluid z.B. technische Gase, die großindustriell hergestellt werden, oder komprimierte Umgebungsluft verwendet werden. Eine einfache Kühlwirkung kann in beiden Fällen durch den plötzlichen Druckabfall beim Ausströmen des Gases aus dem Druckbehälter erzielt werden, insbesondere wenn eine schnelle Kühlung des Hauptkörpers und keine Einpegelung der Temperatur auf einen bestimmten Wert gefordert ist.

Besonders bevorzugt weist eine solche Vorrichtung ferner eine elektrische Temperiervorrichtung auf. Vorteile einer solchen Vorrichtung sind z.B. die einfache Handhabung, Wartungsfreiheit; Steuergeschwindigkeit und Kosten von elektrischen Temperiervorrichtungen, insbesondere von elektrischen Heizelementen.

Vorteilhafter Weise weist die elektrische Temperiervorrichtung ein Peltierelement auf, das als flächige Trennschicht zwischen der ersten und der zweiten Temperiereinrichtung ausgebildet ist. Die Verwendung eines Peltierelementes hat den Vorteil, daß dieses je nach Polung einer angeschlossenen Stromquelle bzw. Schaltungsanordnung sowohl zur Erwärmung als auch zur Kühlung des Hauptkörpers bzw. zur Temperaturmessung dienen kann. Das Peltierelement bevorzugt auch in Verbindung mit einer oder mehreren anderen elektrischen Temperiervorrichtungen Verwendung finden.

Bevorzugt ist ferner eine solche Vorrichtung, bei der die elektrische Temperiervorrichtung eine ausreichend gute Wärmeleitfähigkeit besitzt, um auch in passivem Zustand einen Wärmedurchgang zwischen der ersten und zweiten Temperiereinrichtung zu ermöglichen, d.h. um zu ermöglichen, daß das Substrat, das auf der ersten Temperiervorrichtung angebracht ist, über eine Temperaturdifferenz der zweiten Temperiervorrichtung gekühlt oder erwärmt werden kann.

Ferner wird die Aufgabe erfindungsgemäß durch ein Verfahren zum Temperieren eines Substrats, insbesondere eines Wafers, mit den folgenden Schritten gelöst:
- Bestimmen einer Soll-Temperatur eines Hauptkörpers, auf dem das zu temperierende Substrat angebracht ist, oder des zu temperierenden Substrats,
- Messen bzw. Erfassen der Ist-Temperatur eines Hauptkörpers, auf dem das zu temperierende Substrat angebracht ist, oder des zu temperierenden Substrats,
- Vergleichen der gemessenen bzw. erfaßten Ist-Temperatur mit einer vorbestimmten bzw. vorbestimmbaren und/oder gespeicherten Grenztemperatur,
- Temperieren des Hauptkörpers zumindest mittels einer ersten Temperiervorrichtung, wenn die gemessene Ist-Temperatur um einen ersten vorbestimmten Betrag niedriger ist als die gespeicherte Grenztemperatur,
- Versetzen oder Halten der ersten Temperiervorrichtung in einen Ruhezustand und Temperieren des Hauptkörpers mittels einer anderen Temperiervorrichtung, wenn die gemessene Ist-Temperatur um einen zweiten vorbestimmten Betrag höher ist als die gespeicherte Grenztemperatur.

Die Erfindung wird nachfolgend mit Bezug auf begleitende Zeichnungen bevorzugter Ausführungsformen beispielhaft beschrieben. Diese und andere Aufgaben, Merkmale und Vorteile der vorliegenden Erfindung sind einfacher anhand der folgenden detaillierten Beschreibung bevorzugter Ausführungsformen sowie der begleitenden Zeichnungen zu verstehen. Dabei sollten diese so verstanden werden, daß die Merkmale der verschiedenen Ausführungsformen, auch wenn diese nur in Bezug auf einzelne Ausführungsformen beschrieben werden, so miteinander kombiniert werden können, daß sich weitere Ausführungsformen ergeben. Außerdem werden die Ausführungsformen auch mit lediglich bevorzugten Merkmalen dargestellt, die nicht zwingend vorliegen müssen. Dabei zeigt:
- Fig. 1: einen Querschnitt einer bevorzugten Ausführungsform einer erfindungsgemäßen Vorrichtung zum Temperieren eines Substrats gemäß einer ersten Ausführungsform.
- Fig. 2: einen Querschnitt einer bevorzugten Ausführungsform einer erfindungsgemäßen Vorrichtung zum Temperieren eines Substrats gemäß einer zweiten Ausführungsform.

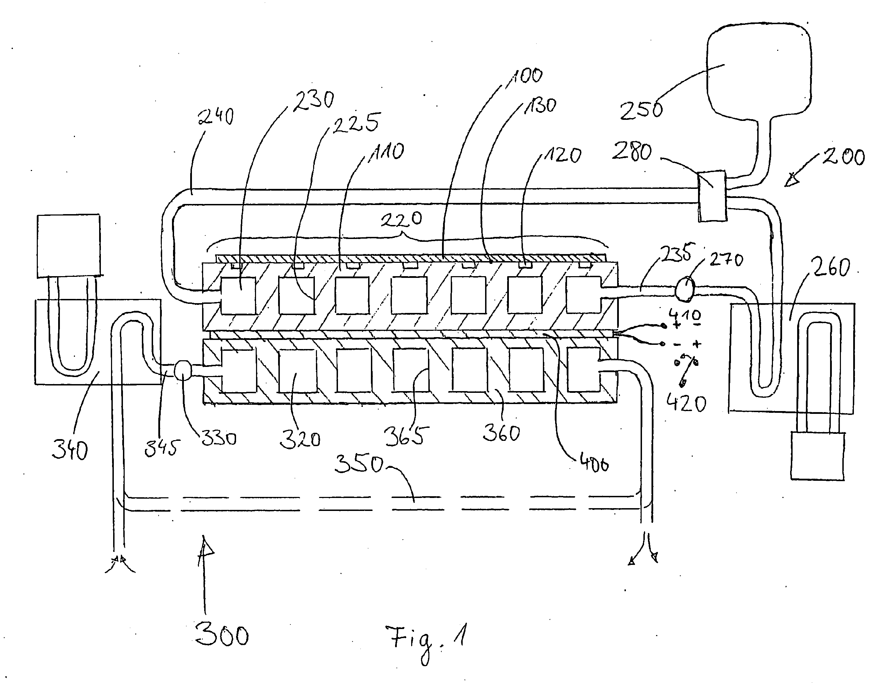

Fig. 1 zeigt einen Querschnitt einer bevorzugten Ausführungsform der erfindungsgemäßen Vorrichtung zum Temperieren eines Substrats 100 (Thermochuck) und insbesondere eines Wafers. Darin weist ein Hauptkörper 110 eine im wesentlichen planare Anlagefläche 130 mit einer Befestigungseinrichtung auf, die in der dargestellten Ausführungsform eine Vielzahl von Ansaugrillen 120 bzw. Ansaugkanälen aufweist. Diese Ansaugrillen 120 sind über nicht dargestellte im Inneren des Hauptkörpers 110 ausgebildete Vakuumkanäle mit zumindest einem ebenfalls nicht gezeigten Vakuumanschluß verbunden. Über diese Vakuumrillen 120 läßt sich ein an der Anlagefläche anzuordnendes Substrat 100 zur Anlagefläche hin ansaugen und an der Anlagefläche halten. Durch die Ansaugung wird das Substrat 100 an die Anlagefläche 130 des Hauptkörpers bzw. des Auflagetisches 110 gepreßt bzw. an dieser angeordnet, wodurch ein guter Wärmeübergangskoeffizient zwischen dem Hauptkörper 110 und dem Substrat 100 gewährleistet ist.

An dem Hauptkörper 110 angrenzend befindet sich die erste Temperiereinrichtung 200. In der dargestellten Ausführungsform ist die erste Temperiereinrichtung 200 im Bereich des temperierten Hauptkörpers 220 einstückig mit dem Hauptkörper 110 verbunden. Der Bereich des temperierten Hauptkörpers 220 weist im Inneren des Hauptkörpers 110 ein oder mehrere erste Temperiermittelkanäle 225 auf. Ein erstes Temperierfluid 230 läuft bzw. fließt in einem ersten Temperiermittelkreislauf 210, der Teil der Temperiereinrichtung 110 ist, und zwar durch diese ersten Temperiermittelkanäle 225, von dort zumindest in eine erste Rückführleitung 240, von dort in zumindest einen ersten Wärmetauscher 260, von dort in zumindest eine erste Zuleitung 235 und von dort zurück in die ersten Temperiermittelkanäle 225 im Bereich des temperierten Hauptkörpers 220.

In dem ersten Temperiermittelkreislauf 210 sorgt bevorzugt eine (nicht dargestellte) erste Fluidpumpe für die gewünschte Zirkulation des ersten Temperierfluids 230.

In der dargestellten Ausführungsform befindet sich unterhalb des Bereichs des temperierten Hauptkörpers 220 eine in der dargestellten Ausführungsform im wesentlichen flächig ausgebildete elektrische Temperiervorrichtung mit einer Stromquelle 410, die z.B. aus Heizdrähten oder ähnlichem bestehen kann.

In der dargestellten Ausführungsform weist die elektrische Temperiervorrichtung 400 ein Peltierelement und die Stromquelle eine Gleichstromquelle 410 auf. Je nach Polung der Gleichstromquelle 410 kann Wärme durch das Peltierelement von der oberen Fläche zur unteren Fläche transportiert werden oder umgekehrt. Gleichzeitig kann das Peltierelement als Temperaturfühler verwendet werden, weil in einem Peltierelement bei unterschiedlichen Temperaturen auf beiden Seiten des Elements ein meßbarer Strom fließt.

Unterhalb der elektrischen Temperiervorrichtung 400 befindet sich in der dargestellten Ausführungsform ein Temperierkörper 360, der in der dargestellten Ausführungsform im Wesentlichen dem Bereich des temperierten Hauptkörpers 220 entspricht. Auch der Temperierkörper 360 weist in seinem Inneren ein oder mehrere zweite Temperiermittelkanäle 365 auf. Auf der Seite einer Temperaturquelle, die in der dargestellten Ausführungsform als zweiter Wärmetauschers 340 ausgeführt ist, sind die Temperiermittelkanäle 365 mit zumindest einer zweiten Zuleitung 345 verbunden, während sie auf der stromabwärtigen Seite mit zumindest einer Ableitung verbunden sind, die in der dargestellten Ausführungsform gestrichelt als zweite Rückführleitung 350 dargestellt ist. In der dargestellten Ausführungsform ist also die zweite Temperiereinrichtung ebenfalls als ein zweiter Temperiermittelkreislauf 310 dargestellt, in der ein zweites Temperierfluid 320 von dem zweiten Wärmetauscher 340, in die zweite Zuleitung 345, durch die zweiten Temperiermittelkanäle 365, in die zweite Rückführleitung 350 und zurück in den zweiten Wärmetauscher 340 zirkuliert.

Alternativ kann die zweite Temperiermitteleinrichtung auch offen ausgeführt werden, so daß das zweite Temperierfluid 320 in der Temperaturquelle auf eine gewünschte Temperatur gebracht wird, an dem Temperierkörper 360 vorbeiströmt bzw. fließt oder diesen durchströmt und anschließend abgeführt wird, ohne erneut in die Temperaturquelle rückgeführt zu werden. Dabei kann das zweite Temperierfluid 320 entweder gänzlich von der Vorrichtung weggeleitet werden oder zur Konditionierung des Raumes um die Vorrichtung verwendet werden.

Grundsätzlich kommen als Fluide für das erste Temperierfluid und/oder das zweite Temperierfluid alle herkömmlichen Fluide in Frage, die in den jeweiligen Temperaturbereichen, in denen sie verwendet werden flüssig und/oder gasförmig vorliegen. Da der Thermochuck aber in einem sehr großen Temperaturbereich von ca. -75° C bis 400° C Anwendung finden soll, werden die erste und zweite Temperiervorrichtung in der dargestellten Ausführungsform in unterschiedlichen sich bevorzugt überschneidenden Temperaturbereichen betrieben. Dabei wird angestrebt, daß die Betriebsdrücke innerhalb der Temperiermittelkreisläufen bei Verwendung von Wasser als Temperiermittelfluid 10 bar nicht übersteigen. Bei Verwendung von anderen flüssigen Temperiermittelfluiden wird angestrebt, daß 4 - 5 bar nicht überschritten werden; bei gasförmigen Fluiden sollte der Wert nicht über 6-7 bar liegen. Höhere maximale Betriebsdrücke können ebenfalls realisierte werden, erfordern aber entsprechende konstruktive Maßnahmen, um der erhörten Belastung entgegenwirken zu können.

So ist es möglich, die erste Temperiereinrichtung 200 unter Verwendung des ersten Temperierfluids 230 auf den ersten Temperaturbereich zwischen einer ersten Temperatur von z.B. -75° C und einer zweiten Temperatur von z.B. 100° C auszulegen, und die zweite Temperiereinrichtung 300 bevorzugt unter Verwendung eines anderen, des zweiten Temperierfluids 320, auf den zweiten Temperaturbereich, der von einer dritten Temperatur von etwa 50° C bis zu einer vierten Temperatur von etwa 200° C reicht. Natürlich können die Temperaturen je nach Ausführungsform von den angegebenen abweichen. Insbesondere die vierte Temperatur kann z.B. bis zu etwa 400° C betragen.

Im dargestellten Temperaturbereich wird in der beschriebenen Ausführungsform als erstes Temperierfluid 230 ein Fluid verwendet im genannten ersten Temperaturbereich in flüssiger Form vorliegt und eine derart geringe Viskosität aufweist, daß es mit geringem Strömungswiderstand durch die Vorrichtung zirkulieren kann. Geeignet hierzu sind z.B. verschiedene Alkohole wie Amylalkohol (Pentanol) und Methanol, aber-auch Heptan. Geeigneter ist ein Thermoöl auf Silikonöl-Basis. Bevorzugt wird ein Temperierfluid verwendet, das perfluorierten Polyether (z.B. unter dem Handelsnamen Galden HT von Solvay Solexis S.p.A. erhältlich), Poly(oxyperfluoro-n-alkylen) (z.B. unter dem Handelsnamen Galden ZT von Solvay Solexis S.p.A. erhältlich) und/oder eine Mischung aus Triethoxyalkylsilanen (z.B. unter dem Handelsnamen DW-Therm von DWS Synthesetechnik erhältlich) enthält. Verwendet werden können aber auch andere dem Fachmann bekannte Stoffe. Da die genannten Stoffe über der zweiten Temperatur nur noch unter beträchtlichem Druck im flüssigen Zustand zu halten sind, wird in der dargestellten Ausführungsform der Betrieb des ersten Temperiermittelkreislaufes 210 über der zweiten Temperatur eingestellt. Da das erste Temperierfluid 230, das im Bereich des temperierten Hauptkörpers 220 verbleibt, bei steigender Temperatur in den gasförmigen Zustand übergehen würde, können geeignete Vorkehrungen getroffen werden, um ein unzulässiges Ansteigen des Drucks im ersten Temperiermittelkreislauf zu verhindern. Dazu kann der Bereich des temperierten Hauptkörpers 220 z.B. über ein Absperrventil 270 und ein Dreiwegeventil 280 vom restlichen ersten Temperiermittelkreislauf 210 abgetrennt werden. Da das in den ersten Temperiermittelkanälen 225 im Bereich des temperierten Hauptkörpers 220 verbleibende erste Temperierfluid 230 dennoch miterhitzt würde und zu einem entsprechenden Druckanstieg führen würde, können über das Dreiwegeventil 280 die ersten Temperiermittelkanäle 225 zur Druckentlastung ferner z.B. mit einem Druckentlastungsbereich 250 verbunden werden, der in der dargestellten bevorzugten Ausführungsform als Reservoir bzw. als Expansionsbehälter ausgebildet ist. Genauso ist es möglich, den Bereich in die Umgebung zu öffnen, das erste Temperierfluid abzupumpen und/oder durch ein anderes Fluid zu ersetzen.

Im Temperaturbereich über der zweiten Temperatur erfolgt die Temperierung der Vorrichtung im wesentlichen über die zweite Temperiereinrichtung 300 und/oder über die elektrische Temperienrorrichtung. Wie bereits in Bezug auf die erste Temperiereinrichtung 200 dargestellt, kann dies ebenfalls über ein geeignetes flüssiges zweites Temperierfluid 320 erfolgen; als besonders vorteilhaft hat sich aber aufgrund der damit verbundenen konstruktiven und wirtschaftlichen Vorteile ein gasförmiges Fluid, insbesondere Luft, erwiesen. Gerade in einem Temperaturbereich über -40° C läßt sich Luft mit vertretbarem technischem Aufwand auf eine relative Luftfeuchtigkeit trocknen, die bei Umgebungsdruck im wesentlichen noch nicht zu ungewünschter Kondenswasserbildung führt. Eine weitere Trocknung ist ebenfalls möglich, so daß die zweite Temperiereinrichtung 300 grundsätzlich auch bis zur ersten Temperatur und darüber hinaus eingesetzt werden kann. Im übrigen ist Luft leicht zu temperieren, annähernd beliebig zu erhitzen, zu komprimieren, überall und ohne zusätzliche Kosten erhältlich und ungiftig.

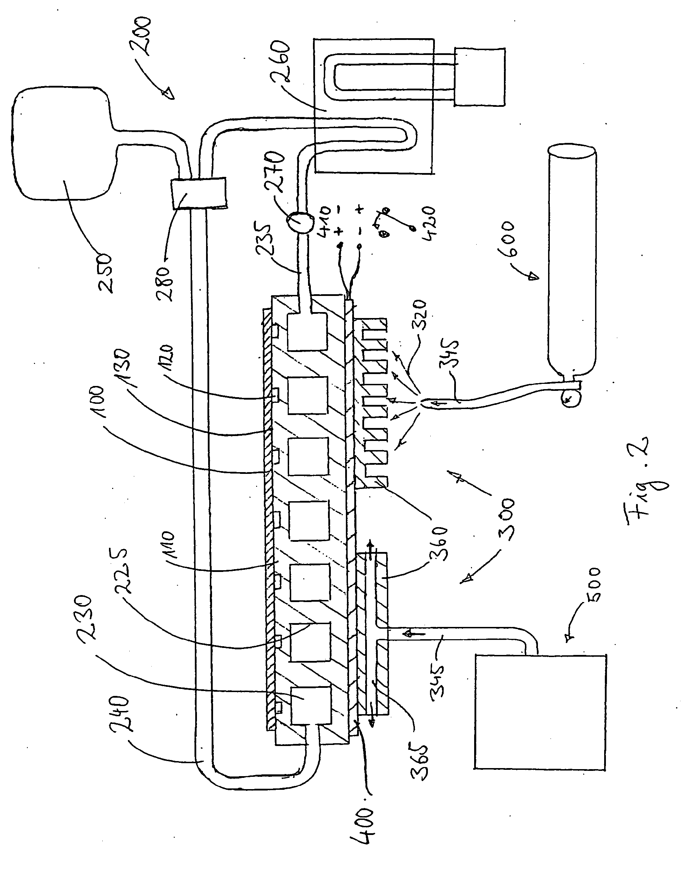

Wenn schnelle Abkühlung der Vorrichtung gewünscht ist, kann Luft z.B. schnell aus einem evtl. vorgekühlten Druckbehälter 600 entweichen gelassen werden, so daß durch den schnellen Druckabfall eine Abkühlung herbeigeführt wird, ohne die Luft in einem Wärmetauscher oder einer anderen Temperiervorrichtung abkühlen zu müssen, wie in der Ausführungsform in Figur 2 auf der rechten Seite gezeigt ist. In Fig. 2 werden vergleichbare Merkmale mit den gleichen Bezugszeichen bezeichnet, wie in Fig. 1. Die erreichbaren Fluidtemperaturen sind für eine Abkühlung der Vorrichtung in einem hohen Temperaturbereich insbesondere in einem Bereich über der zweiten Temperatur aufgrund des großen Temperaturunterschiedes in der Regel vollkommen ausreichend. Außer Luft können natürlich auch andere Gase wie z.B. Stickstoff verwendet werden.

Wenn die zweite Temperiereinrichtung 300 als offenes System verwendet wird, das z.B. Umgebungsluft über eine Luftaufbereitungsanlage 500 aus dem Raum um die Vorrichtung herum ansaugt, diese auf einen gewünschten Wert trocknet, gegebenenfalls komprimiert und temperiert und an dem Temperierkörper 360 vorbei wieder zurück in den Raum strömen läßt, ist über die zweite Temperiervorrichtung 300 zusätzlich eine Konditionierung der Umgebung um die Vorrichtung möglich.

Bei einer Ausgestaltung der zweiten Temperiervorrichtung 300 als offenes System kann der Temperierkörper auch ohne geschlossene zweite Temperiermittelkanäle 365 ausgebildet sein, z.B. mit Kühlrippen, die über eine Anströmvorrichtung wie z.B. einen Druckbehälter 600 mit einer angeschlossenen Luftdüse, einem Ventilator, etc. angeblasen werden, wie in Fig. 2 auf der rechten Seite gezeigt. Vorzugsweise sind in dem Temperierkörper aber zentral ausgehend von einer oder wenigen Eintrittöffnungen eine Vielzahl von Kanälen ausgebildet, die in einer Vielzahl von Fluidaustrittsöffnungen münden, wie in Fig. 2 auf der linken Seite gezeigt. Damit kann eine besonders effiziente Verteilung des Fluidstroms über den ganzen Bereich des temperierten Hauptkörpers bewirkt werden.

Die beiden Temperiereinrichtungen können auch in dem überlappenden Temperaturbereich parallel Verwendung finden, so daß sie gemeinsam eingesetzt zu noch schnelleren Temperaturwechseln führen können. Genauso ist ein Betrieb denkbar, bei dem zusätzlich zu der ersten und/oder der zweiten Temperiervorrichtung 200, 300 die elektrische Temperiervorrichtung 400 eingesetzt wird. Weiterhin denkbar ist, daß die zweite Temperiervorrichtung 300 lediglich als Kühlvorrichtung eingesetzt wird, wenn schnelle Abkühlvorgänge erforderlich sind.

Die Materialien des Hauptkörpers, der ersten und zweiten Temperiereinrichtung und/oder einzelner Teile umfassen nicht abschließend Stahl, andere Metalle und Keramik. Besonders bevorzugte Gestaltungsmöglichkeiten dieser Teile auch in Bezug auf den Verlauf der Strömungskanäle sind im einzelnen z.B. in der DE 20 2005 005 052 U beschrieben. Die Kanäle können zusätzlich, wie z.B. ebenfalls in der DE 20 2005 005 052 U beschrieben ist, auch Beschichtungen aufweisen, welche das Substrat z.B. gegen elektromagnetische Felder abschirmt. Auf dieses Dokument wird daher ausdrücklich Bezug genommen. Vorteilhaft ist ferner, wenn die beschriebene Vorrichtung ein Gehäuse aufweist, z.B. zum Schutz gegen Eindringen von Schmutz und/oder mechanischen Einflüssen, oder gegen den Austritt von Fluiden aus dem Inneren der Vorrichtung.

### Bezugszeichenliste

- 100: Substrat
- 110: Hauptkörper
- 120: Befestigungseinrichtung
- 130: Anlagefläche
- 200: Erste Temperiereinrichtung
- 210: Erster Temperiermittelkreislauf
- 220: Bereich des temperierten Hauptkörpers
- 225: Erste Temperiermittelkanäle
- 230: Erstes Temperierfluid
- 235: Erste Zuleitung
- 240: Erste Rückführleitung
- 250: Druckentlastungsbereich
- 260: Erster Wärmetauscher (enthält Erste Kreislaufpumpe)
- 270: Erstes Absperrventil
- 280: Dreiwegeventil
- 300: Zweite Temperiereinrichtung
- 310: Zweiter Temperiermittelkreislauf
- 320: Zweites Temperierfluid
- 330: Zweites Absperrventil
- 340: Zweiter Wärmetauscher (enthält Zweite Kreislaufpumpe)
- 345: Zweite Zuleitung
- 350: Zweite Rückführleitung
- 360: Temperierkörper
- 365: Zweite Temperiermittelkanäle
- 400: Elektrische Temperiervorrichtung
- 410: Stromquelle
- 420: Umpolvorrichtung
- 500: Luftaufbereitungsanlage
- 600: Druckbehälter

## Patentansprüche

1. Vorrichtung zum Temperieren eines Substrats (100), insbesondere eines Wafers, wobei die Vorrichtung einen durch eine erste Temperiervorrichtung (200) und eine zweite Temperiereinrichtung (300) temperierten Hauptkörper (110) aufweist, wobei
die erste Temperiereinrichtung (200) zur Temperierung des Hauptkörpers (110) in einem ersten Temperaturbereich zwischen einer ersten Temperatur und einer zweiten Temperatur konfiguriert ist, wobei die erste Temperatur niedriger als die zweite Temperatur ist, und mittels eines ersten Temperierfluids (230) temperiert wird, und
die zweite Temperiereinrichtung (300) zur Temperierung des Hauptkörpers (110) in einem zweiten Temperaturbereich zwischen einer dritten Temperatur und einer vierten Temperatur konfiguriert ist, wobei die dritte Temperatur niedriger als die vierte Temperatur ist, und die zweite Temperiereinrichtung (300) mittels eines zweiten Temperierfluids (320) temperiert wird, wobei die zweite Temperatur niedriger als die vierte Temperatur ist und sich das erste Temperierfluid (230) vom zweiten Temperierfluid (320) unterscheidet; **dadurch gekennzeichnet, daß**
der Hauptkörper (110) eine im wesentlichen planare Anlagefläche (130) mit einer Befestigungseinrichtung zum Befestigen eines Substrats (100) aufweist, die eine Vielzahl von Ansaugrillen (120) aufweist,
im Inneren des Hauptkörpers (110) ein oder mehrere erste Temperiermittelkanäle (225) für das erste Temperierfluid (230) vorgesehen sind und
die zweite Temperiereinrichtung (300) zur Temperierung des darüberliegenden Hauptkörpers (110) einen Temperierkörper (360) umfaßt, der in seinem Inneren ein oder mehrere zweite Temperiermittelkanäle (365) für das zweite Temperierfluid (320) aufweist.

2. Vorrichtung nach Anspruch 1, bei der das erste Temperierfluid (230) Alkohol, ein Thermoöl auf Silikonöl-Basis, perfluorierten Polyether, Poly(oxyperfluoro-n-alkylen) und/oder eine Mischung aus Triethoxyalkylsilanen enthält.

3. Vorrichtung nach Anspruch 1 oder 2, bei der das zweite Temperierfluid (320) Luft oder Stickstoff ist.

4. Vorrichtung nach einem der vorstehenden Ansprüche, wobei die erste Temperiereinrichtung (200) einen ersten Temperiermittelkreislauf aufweist, der zur Temperierung von dem ersten Temperierfluid (230) durchströmt wird, wobei der erste Temperiermittelkreislauf (210) derart gestaltet ist, daß das erste Temperierfluid (230), wenn es den Bereich des zu temperierenden Hauptkörpers (220) durchströmt hat, zumindest im Betriebsbereich zwischen der ersten Temperatur und der zweiten Temperatur zumindest zum Teil in dem ersten Temperiermittelkreislauf verbleibt.

5. Vorrichtung nach Anspruch 4, wobei das erste Temperierfluid (230) im Temperaturbereich zwischen der ersten Temperatur und der zweiten Temperatur bis zu einem vorgegebenen ersten Maximaldruck einen flüssigen Aggregatszustand aufweist.

6. Vorrichtung nach einem der Ansprüche 4 oder 5, die so gestaltet ist, daß der Teil des ersten Temperiermittelkreislaufes, der sich in dem Bereich des temperierten Hauptkörpers (220) befindet, von dem restlichen Bereich des ersten Temperierkreislaufes abgesperrt werden kann und mit einem Drukkentlastungsbereich (250) verbunden werden kann.

7. Vorrichtung nach einem der vorstehenden Ansprüche, wobei die zweite Temperiereinrichtung (300) zur Temperierung des Hauptkörpers (110) einen zweiten geschlossenen Temperiermittelkreislauf aufweist, der zur Temperierung von dem zweiten Temperierfluid (320) durchströmt wird.

8. Vorrichtung nach Anspruch 7, wobei das zweite Temperierfluid (320) im Temperaturbereich zwischen der dritten Temperatur und der vierten Temperatur bis zu einem vorgegebenen zweiten Maximaldruck einen flüssigen Aggregatszustand aufweist.

9. Vorrichtung nach Anspruch 7, wobei das zweite Temperierfluid (320) im Temperaturbereich zwischen der dritten Temperatur und der vierten Temperatur einen gasförmigen Aggregatszustand aufweist.

10. Vorrichtung nach einem der Ansprüche 1 - 6, wobei die zweite Temperiereinrichtung (300) zur Temperierung des Hauptkörpers eine Anströmvorrichtung (500, 600) aufweist, wobei die Anströmvorrichtung (500, 600) so gestaltet ist, daß sie den Temperierkörper (360) durch das zweite Temperierfluid (320) anströmen lassen kann, wobei die zweite Temperiervorrichtung (300) so gestaltet ist, daß das zweite Temperierfluid (320), nachdem es den Temperierkörper (360) angeströmt hat, nicht wieder in einen Temperierfluidkreislauf rückgeführt wird.

11. Vorrichtung nach einem der vorstehenden Ansprüche, die ferner eine elektrische Temperiervorrichtung (400) aufweist.

12. Vorrichtung nach Anspruch 11, wobei die elektrische Temperiervorrichtung (400) ein Peltierelement aufweist, das als flächige Trennschicht zwischen der ersten und der zweiten Temperiereinrichtung ausgebildet ist.

13. Vorrichtung nach einem der vorstehenden Ansprüche, bei der die erste Temperatur in etwa -75° C (198,15 Kelvin) und die vierte Temperatur etwa 400° C (673,15 Kelvin) beträgt und die zweite Temperatur bei etwa 300° C (573,15 Kelvin), besser noch bei etwa 200° C (473,15 Kelvin) und am vorteilhaftesten bei etwa 100° C (373,15 Kelvin) liegt und bei der die dritte Temperatur bevorzugt im Bereich der ersten Temperatur besser bei ca. -55° C und noch besser bei etwa 45° C liegt.

14. Verfahren zum Temperieren eines Substrats (100), insbesondere eines Wafers, unter Verwendung einer Vorrichtung nach einem der vorherigen Ansprüche, wobei das Verfahren folgende Schritte aufweist:
- Bestimmen einer Soll-Temperatur eines Hauptkörpers (110), auf dem das zu temperierende Substrat angebracht oder anzubringen ist, oder des zu temperierenden Substrats (100),
- Erfassen der Ist-Temperatur des Hauptkörpers (110), auf dem das zu temperierende Substrat (100) angebracht ist, oder des zu temperierenden Substrats (100),
- Vergleichen der erfaßten Ist-Temperatur mit einer vorbestimmten Soll-Temperatur
- Temperieren des Hauptkörpers zumindest mittels einer ersten Temperiervorrichtung (200), wenn die erfaßte Ist-Temperatur um einen ersten vorbestimmten Betrag niedriger ist als die gespeicherte Soll-Temperatur,
- Versetzen oder Halten der ersten Temperiervorrichtung (200) in einen Ruhezustand und Temperieren des Hauptkörpers mittels einer anderen Temperiervorrichtung (300, 400), wenn die gemessene Ist-Temperatur um einen zweiten vorbestimmten Betrag höher ist als die vorbestimmte Soll-Temperatur

## Claims

1. An apparatus for regulating the temperature of a substrate (100), in particular of a wafer, wherein the apparatus has a main body (110) whose temperature is regulated by a first temperature-regulating device (200) and by a second temperature-regulating device (300), wherein
the first temperature-regulating device (200) is configured to regulate the temperature of the main body (110) in a first temperature range between a first temperature and a second temperature, the first temperature being lower than the second temperature, and is temperature regulated by means of a first temperature-regulating fluid (230), and
the second temperature-regulating device (300) is configured to regulate the temperature of the main body (110) in a second temperature range between a third temperature and a fourth temperature, the third temperature being lower than the fourth temperature, and the second temperature-regulating device (300) is temperature regulated by means of a second temperature-regulating fluid (320), wherein
the second temperature is lower than the fourth temperature and the first temperature-regulating fluid (230) differs from the second temperature-regulating fluid (320);
**characterized in that**
the main body (110) has a substantially planar contact surface (130) with an attachment device for attaching a substrate (100), which has a plurality of suction grooves (120),
one or more first temperature-regulating means ducts (225) for the first temperature-regulating fluid (230) are provided in the inside of the main body (110), and
for regulating the temperature of the above-lying main body (110), the second temperature-regulating device (300) comprises a temperature-regulating body (360) having one or more second temperature-regulating means ducts (365) for the second temperature-regulating fluid (320) in the inside thereof.

2. The apparatus as claimed in claim 1, in which the first temperature-regulating fluid (230) contains alcohol, a silicone oil-based thermal oil, perfluorinated polyether, poly(oxyperfluoro-n-alkylene) and/or a mixture of triethoxyalkylsilanes.

3. The apparatus as claimed in claim 1 or 2, in which the second temperature-regulating fluid (320) is air or nitrogen.

4. The apparatus as claimed in one of the preceding claims, wherein the first temperature-regulating device (200) has a first temperature-regulating means circuit, through which the first temperature-regulating fluid (230) flows in order to regulate the temperature, wherein the first temperature-regulating means circuit (210) is designed such that the first temperature-regulating fluid (230), once it has flowed through the region of the main body (220) to be temperature regulated, remains in the first temperature-regulating means circuit at least partially at least in the operating range between the first temperature and the second temperature.

5. The apparatus as claimed in claim 4, wherein the first temperature-regulating fluid (230) in the temperature range between the first temperature and the second temperature up to a predetermined first maximum pressure has a liquid aggregate state.

6. The apparatus as claimed in one of claims 4 or 5, which is designed such that that part of the first temperature-regulating means circuit situated in the region of the temperature-regulated main body (220) can be shut off from the remaining region of the first temperature-regulating circuit and be connected to a pressure-relief region (250).

7. The apparatus as claimed in one of the preceding claims, wherein the second temperature-regulating device (300) for regulating the temperature of the main body (110) has a second closed temperature-regulating means circuit through which the second temperature-regulating fluid (320) flows in order to regulate the temperature.

8. The apparatus as claimed in claim 7, wherein the second temperature-regulating fluid (320) has, in the temperature range between the third temperature and the fourth temperature, a liquid aggregate state up to a predetermined second maximum pressure.

9. The apparatus as claimed in claim 7, wherein the second temperature-regulating fluid (320), in the temperature range between the third temperature and the fourth temperature, has a gaseous aggregate state.

10. The apparatus as claimed in one of claims 1-6, wherein the second temperature-regulating device (300) for regulating the temperature of the main body has an incident-flow apparatus (500, 600), wherein the incident-flow apparatus (500, 600) is designed such that it can cause the flow of the second temperature-regulating fluid (320) to be incident on the temperature-regulating body (360), wherein the second temperature-regulating apparatus (300) is designed such that the second temperature-regulating fluid (320) is not returned again into a temperature-regulating fluid circuit after it was incident on the temperature-regulating body (360).

11. The apparatus as claimed in one of the preceding claims, which further has an electric temperature-regulating apparatus (400).

12. The apparatus as claimed in claim 11, wherein the electric temperature-regulating apparatus (400) has a Peltier element, which is designed as an areal separating layer between the first and the second temperature-regulating devices.

13. The apparatus as claimed in one of the preceding claims, in which the first temperature is approximately -75° C (198.15 Kelvin) and the fourth temperature is approximately 400° C (673.15 Kelvin) and the second temperature is approximately 300° C (573.15 Kelvin), even better approximately 200° C (473.15 Kelvin) and most advantageously approximately 100° C (373.15 Kelvin) and in which the third temperature is preferably in the range of the first temperature, better approximately -55° C and even better approximately 45° C.

14. A method for regulating the temperature of a substrate (100), in particular of a wafer, using an apparatus as claimed in one of the preceding claims, the method comprising the following steps:
- determining a target temperature of a main body (110) on which the substrate whose temperature is to be regulated is applied or is to be applied, or of the substrate (100) whose temperature is to be regulated,
- detecting the actual temperature of the main body (110) on which the substrate (100) whose temperature is to be regulated is applied, or of the substrate (100) whose temperature is to be regulated,
- comparing the detected actual temperature with a predetermined target temperature,
- regulating the temperature of the main body at least by means of a first temperature-regulating apparatus (200) if the measured actual temperature is lower than the stored target temperature by a first predetermined amount,
- bringing the first temperature-regulating apparatus (200) into a rest state, or keeping it there, and regulating the temperature of the main body by means of another temperature-regulating apparatus (300, 400) if the measured actual temperature is higher than the predetermined target temperature by a second predetermined amount.

## Revendications

1. Dispositif de thermostatisation d'un substrat (100), en particulier d'une tranche de silicium, le dispositif comprenant un corps principal (110) tempéré par un premier dispositif de thermostatisation (200) et un deuxième dispositif de thermostatisation (300), dans lequel
le premier dispositif de thermostatisation (200) est configuré pour tempérer le corps principal (110) dans une première plage de températures entre une première température et une deuxième température, la première température étant inférieure à la deuxième température, et est tempéré au moyen d'un premier fluide de thermostatisation (230), et
le deuxième dispositif de thermostatisation (300) est configuré pour tempérer le corps principal (110) dans une deuxième plage de températures entre une troisième température et une quatrième température, la troisième température étant inférieure à la quatrième température, et le deuxième dispositif de thermostatisation (300) est tempéré au moyen d'un deuxième fluide de thermostatisation (320), dans lequel
la deuxième température est inférieure à la quatrième température et le premier fluide de thermostatisation (230) se distingue du deuxième fluide de thermostatisation (320) ;
**caractérisé en ce que**
le corps principal (110) présente une surface d'appui essentiellement planaire (130) avec un dispositif de fixation pour fixer un substrat (100), comprenant une pluralité de grilles d'aspiration (120),
un ou plusieurs premiers canaux d'agents de thermostatisation (225) sont prévus à l'intérieur du corps principal (110) pour le premier fluide de thermostatisation (230), et
le deuxième dispositif de thermostatisation (300) pour tempérer le corps principal sus-jacent (110) comprend un corps de thermostatisation (360) qui présente dans sa partie interne un ou plusieurs deuxièmes canaux d'agents de thermostatisation (365) pour le deuxième fluide de thermostatisation (320).

2. Dispositif selon la revendication 1, dans lequel le premier fluide de thermostatisation (230) contient de l'alcool, une huile thermique à base d'huile de silicone, du polyéther perfluoré, des poly(oxyperfluoro-n-alkyles) et/ou un mélange de triethoxyalkylsilanes.

3. Dispositif selon les revendications 1 ou 2, dans lequel le deuxième fluide de thermostatisation (320) est de l'air ou de l'azote.

4. Dispositif selon une des revendications précédentes, dans lequel le premier dispositif de thermostatisation (200) présente un premier circuit d'agent de thermostatisation qui est parcouru pour la thermostatisation par le premier fluide de thermostatisation (230), le premier circuit de thermostatisation (210) étant conçu de telle sorte que le premier fluide de thermostatisation (230), lorsqu'il a parcouru la région du corps principal à tempérer (220), demeure au moins dans la plage de service entre la première température et la deuxième température au moins partiellement dans le premier circuit d'agent de thermostatisation.

5. Dispositif selon la revendication 4, dans lequel le premier fluide de thermostatisation (230) présente un état physique liquide dans la plage de températures entre la première température et la deuxième température jusqu'à une première pression maximale définie.

6. Dispositif selon une des revendications 4 ou 5, qui est configuré de telle sorte que la partie du premier circuit d'agent de thermostatisation qui se trouve dans la région du corps principal tempéré (220) peut être coupée de la zone résiduelle du premier circuit de thermostatisation et peut être reliée à une zone de décompression (250).

7. Dispositif selon une des revendications précédentes, dans lequel le deuxième dispositif de thermostatisation (300) pour tempérer le corps principal (110) présente un deuxième circuit d'agent de thermostatisation fermé qui est parcouru en vue de la thermostatisation par le deuxième fluide de thermostatisation (320).

8. Dispositif selon la revendication 7, dans lequel le deuxième fluide de thermostatisation (320) présente un état physique liquide dans la plage de températures entre la troisième température et la quatrième température jusqu'à une deuxième pression maximale définie.

9. Dispositif selon la revendication 7, dans lequel le deuxième fluide de thermostatisation (320) présente un état physique gazeux dans la plage de températures entre la troisième température et la quatrième température.

10. Dispositif selon une des revendications 1 à 6, dans lequel le deuxième dispositif de thermostatisation (300) présente pour tempérer le corps principal un dispositif de soufflage (500, 600), le dispositif de soufflage (500, 600) étant configuré de telle sorte qu'il peut exposer à la soufflerie le corps de thermostatisation (360) à travers le deuxième fluide de thermostatisation (320), le deuxième dispositif de thermostatisation (300) étant conçu de telle sorte que le deuxième fluide de thermostatisation (320), après avoir soufflé sur le corps de thermostatisation (360), n'est pas redirigé dans un circuit de fluide de thermostatisation.

11. Dispositif selon une des revendications précédentes, présentant en outre un dispositif de thermostatisation électrique (400).

12. Dispositif selon la revendication 11, dans lequel le dispositif de thermostatisation électrique (400) présente un élément Peltier qui se présente sous la forme d'une couche de séparation plane entre le premier et le deuxième dispositif de thermostatisation.

13. Dispositif selon une des revendications précédentes, dans lequel la première température s'élève à environ -75 °C (198,15 Kelvin) et la quatrième température à environ 400 °C (673,15 Kelvin), et la deuxième température s'élève à environ 300 °C (573,15 Kelvin), de préférence à environ 200 °C (473,15 Kelvin) et de façon la plus préférentielle à environ 100 °C (373,15 Kelvin), et dans lequel la troisième température se situe de préférence dans la plage de la première température, de façon préférentielle à environ -55 °C et de façon encore plus préférentielle à environ 45 °C.

14. Procédé de thermostatisation d'un substrat (100), en particulier d'une tranche de silicium, à l'aide d'un dispositif selon une des revendications précédentes, le procédé comprenant les étapes suivantes :
- détermination d'une température théorique d'un corps principal (110), sur lequel est appliqué ou doit être appliqué le substrat à tempérer, ou du substrat à tempérer (100),
- détection de la température effective du corps principal (110), sur lequel est appliqué le substrat à tempérer (100), ou du substrat à tempérer (100),
- comparaison de la température effective détectée à une température théorique prédéfinie,
- thermostatisation du corps principal au moins au moyen d'un premier dispositif de thermostatisation (200), si la température effective détectée est inférieure, selon un premier niveau prédéfini, à la température théorique enregistrée,
- déplacement ou maintien du premier dispositif de thermostatisation (200) dans un état de repos et thermostatisation du corps principal au moyen d'un autre dispositif de thermostatisation (300, 400), si la température effective mesurée est supérieure, selon un deuxième niveau prédéfini, à la température théorique prédéfinie.
